# EUROPEAN PATENT APPLICATION

(11) **EP 4 818 813 A1**
(43) Date of publication of application: **07.10.2026**
(21) Application number: 26165369.5
(22) Date of filing: 17.03.2026
(51) Int. Cl.: G03G 15/00, G03G 15/06

(54) **HIGH-VOLTAGE POWER SUPPLY BOARD, ELECTRONIC DEVICE, AND IMAGE FORMING APPARATUS**

(30) Priority: 04.04.2025 JP 2025062508
(71) Applicant: KYOCERA Document Solutions Inc., Osaka-shi, Osaka 540-8585 (JP)
(72) Inventor: SHINBA, Minoru, Osaka-shi, Osaka, 540-8585 (JP)
(74) Representative: Herrero & Asociados, S.L.

(57) **Abstract**

In a high-voltage power supply board (10) having a rectangular outline, a plurality of first output terminals (111) that output high-voltage power to drum units are provided on a region of the high-voltage power supply board (10) located alongside of one lateral edge (101) thereof, while a plurality of second output terminals (121) that output high-voltage power to developing units are provided on a region of the high-voltage power supply board (10) located alongside of another lateral edge (102) of the high-voltage power supply board (10) opposite to the one lateral edge (101) thereof.

## Description

### BACKGROUND

The present invention relates to high-voltage power supply boards, electronic devices, and image forming apparatuses.

Generally, an image forming apparatus that forms an image on a recording medium, for example, an image forming apparatus of an electrophotographic system, is equipped with a high-voltage power supply board that outputs high-voltage power to drum units and developing units. In the case where the high-voltage power supply board has a rectangular outline in which a pair of opposite two sides are longer than the other pair of opposite two sides, terminals that output high-voltage power to the units of both types described above are arranged in a line on a region of the board close to one lateral edge thereof forming one of the longer two sides. The reason for this is that the associated drum unit and developing unit are disposed close to each other in the interior of the apparatus body of the image forming apparatus and terminals for both the units need to be disposed close to each other in order to output high-voltage power to these units.

### SUMMARY

A technique improved over the aforementioned technique is proposed as one aspect of the present invention.

A high-voltage power supply board according to one aspect of the present invention is a high-voltage power supply board having a rectangular outline, wherein a plurality of first output terminals that output high-voltage power to first operating units are provided on a region of the high-voltage power supply board located alongside of one lateral edge of the high-voltage power supply board, while a plurality of second output terminals that output high-voltage power to second operating units different from the first operating units are provided on a region of the high-voltage power supply board located alongside of another lateral edge of the high-voltage power supply board opposite to the one lateral edge thereof.

An electronic device according to another aspect of the present invention includes the high-voltage power supply board according to the one aspect of the present invention and a mount. The mount is provided in an apparatus body and the high-voltage power supply board is mounted on the mount. The mount is provided with high-voltage output lines each of which makes a connection with one of the first output terminal and the second output terminal and is wired from a location of the connection to a location close to the other of the first output terminal and the second output terminal, while keeping an insulating distance from a soldering surface provided on the high-voltage power supply board.

An image forming apparatus according to still another aspect of the present invention includes: the high-voltage power supply board according to the one aspect of the present invention; an image forming device including developing units and photosensitive drum units; and a mount. The developing units are the first operating units. The photosensitive drum units are the second operating units. The image forming device forms an image on a recording medium. The mount is provided in an apparatus body and the high-voltage power supply board is mounted on the mount. The mount is provided with high-voltage output lines each of which makes a connection with one of the first output terminal and the second output terminal and is wired from a location of the connection to a location close to the other of the first output terminal and the second output terminal, while keeping an insulating distance from a soldering surface provided on the high-voltage power supply board.

### BRIEF DESCRIPTION OF THE DRAWINGS

FIG. 1 is a frontal cross-sectional view showing the structure of an image forming apparatus according to one embodiment of the present invention.
FIG. 2A is a view showing an example of a high-voltage power supply board and a plan view showing the front surface of the board.
FIG. 2B is a view showing the example of the high-voltage power supply board and a plan view showing the back surface of the board.
FIG. 3 is a view showing a comparative example to the high-voltage power supply board according to the one embodiment of the present invention.
FIG. 4 is a picture illustrating an example of wiring patterns on the high-voltage power supply board through which a connector is connected to first high-voltage generating circuits and second high-voltage generating circuits.
FIG. 5A is a view showing an example of a mount on which the high-voltage power supply board is to be mounted, and a plan view showing one side of the mount.
FIG. 5B is a view showing the example of the mount on which the high-voltage power supply board is to be mounted, and a plan view showing the other side of the mount.
FIG. 6 is a view showing a first output terminal portion of the high-voltage power supply board mounted on the mount.

### DETAILED DESCRIPTION

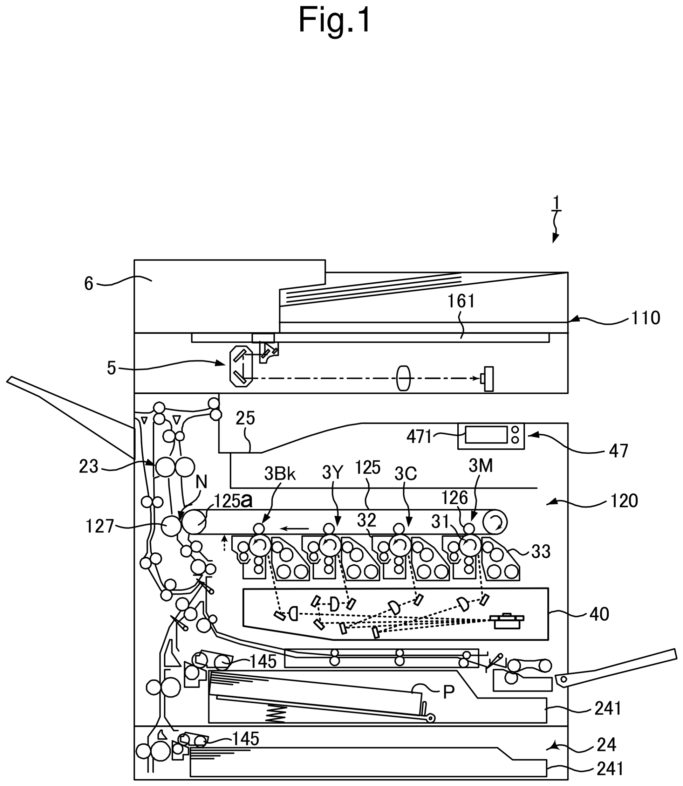

Hereinafter, a description will be given of a high-voltage power supply board, an electronic device, and an image forming apparatus each according to one embodiment of the present invention with reference to the drawings. FIG. 1 is a frontal cross-sectional view showing the structure of an image forming apparatus 1 according to one embodiment of the present invention. The image forming apparatus 1 is an example of an electronic device according to the present invention. The image forming apparatus 1 is, for example, a multifunction peripheral having multiple functions, such as a copy function, a print function, a scan function, and a facsimile function, or an image forming apparatus, such as a copier, a printer or a facsimile device. Although the description in this embodiment is given by taking as an example a multi-color image forming apparatus, the image forming apparatus according to the present invention may be an image forming apparatus for black-and-white printing.

The image forming apparatus 1 has a structure in which an apparatus body 110 is provided with an input acceptance device 47, an image forming device 120, a fixing device 23, a sheet feed device 24, a document feed device 6, an image reading device 5, and so on.

In a document reading operation of the image forming apparatus 1, the image reading device 5 optically reads a sheet of original document conveyed by the document feed device 6 or a sheet of original document placed on an original glass plate 161 and generates image data representing the image of the sheet of original document. The image data generated by the image reading device 5 is saved in a built-in HDD, a computer connected via a network, or so on.

In an image forming operation of the image forming apparatus 1, the image forming device 120 forms, based on the image data generated in the document reading operation, a toner image on a sheet P as a recording medium fed from the sheet feed device 24. In doing multi-color printing, each of an image forming unit 3M for magenta, an image forming unit 3C for cyan, an image forming unit 3Y for yellow, and an image forming unit 3Bk for black, all included in the image forming device 120, forms, based on an image consisting of an associated color component forming part of the image data, a toner image on a photosensitive drum (an image carrier) 31 through charging, exposure, and development processes and allows the toner image to be transferred onto an intermediate transfer belt 125 by a primary transfer roller 126.

The image forming units 3M, 3C, 3Y, and 3Bk include respective toner cartridges (not shown) for the respective associated colors. The toner cartridges accommodate respective toners of associated colors as consumable supplies that will be consumed by image formation on sheets by the image forming device 120. The toner cartridges are detachable from the respective associated image forming units 3M, 3C, 3Y, and 3Bk. When the toner cartridge becomes empty, the user exchanges it for a new one.

The respective toner images of different colors primarily transferred onto the intermediate transfer belt 125 are superimposed on the intermediate transfer belt 125 by adjusting the transfer timings, resulting in formation of a multi-color toner image. A secondary transfer roller 125a transfers the multi-color toner image formed on the surface of the intermediate transfer belt 125, at a nip N between the secondary transfer roller 125a and a drive roller 127 with the intermediate transfer belt 125 in between, to a sheet P being conveyed through a sheet conveyance path from the sheet feed device 24. Thereafter, the fixing device 23 fixes the toner image on the sheet P by application of heat and pressure. Then, the sheet P is ejected to a sheet output tray 25.

The sheet feed device 24 includes a plurality of sheet feed cassettes 241. Each of the sheet feed cassette 241 accommodates sheets P to be conveyed to the image forming device 120. When a controller 91 to be described hereinafter drives a pick-up roller 145 for each of the sheet feed cassettes 241 into rotation, the pick-up roller 145 allows the sheets P accommodated in the associated sheet feed cassette 241 to be conveyed sheet by sheet toward the image forming device 120.

Next, a description will be given of the image forming units 3M, 3C, 3Y, and 3Bk. Around the rotatably disposed photosensitive drum 31, a charging device 32 that charges the photosensitive drum 31, an optical scanning device 40 that exposes the photosensitive drum 31 with light corresponding to image information based on the image data, a developing device 33 that forms a toner image on the photosensitive drum 31, and a cleaning device that removes residual toner on the photosensitive drum 31 are provided. For example, the photosensitive drum 31 and the charging device 32 constitute a photosensitive drum unit (hereinafter, referred to simply as a drum unit), and the developing device 33 constitutes a developing unit.

In each of the image forming units 3M, 3C, 3Y, and 3Bk, the surface of the photosensitive drum 31 are uniformly charged and scanned with light beams emitted from the optical scanning device 40, an electrostatic latent image is thus formed on the photosensitive drum 31, and the electrostatic latent image is developed by a toner and thus formed into a toner image. The toner image formed on the surface of the photosensitive drum 31 is transferred to the intermediate transfer belt 125. The image forming units 3M, 3C, 3Y, and 3Bk superimpose their respective associated toner images on the intermediate transfer belt 125 and allows them to be transferred to the intermediate transfer belt 125, and, thus a multi-color toner image is formed.

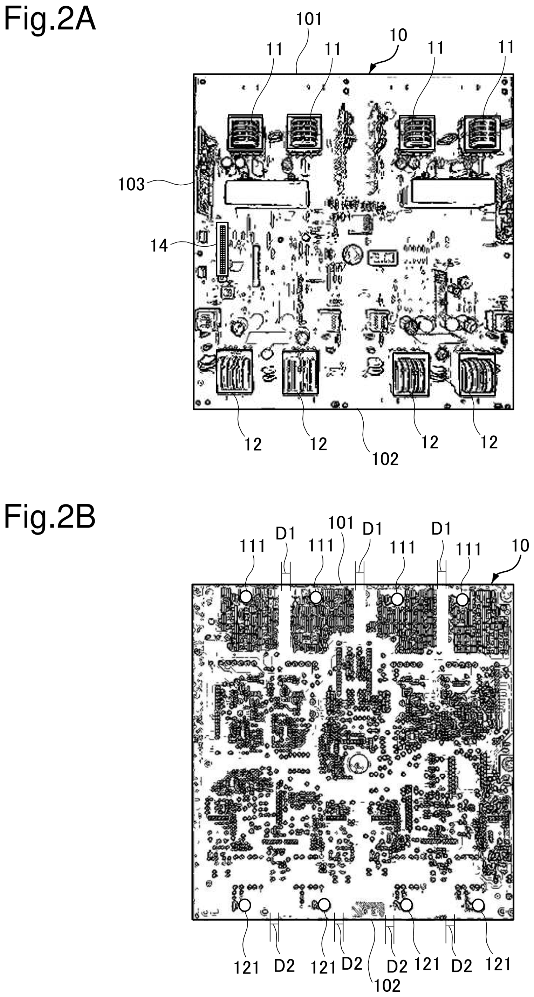

Next, a description will be given of a high-voltage power supply board that supplies high-voltage power to operating units mounted in the image forming apparatus 1. Herein, the description will be given by taking as an example a high-voltage power supply board that supplies high-voltage power to the above-described drum units and developing units. FIG. 2 shows views showing an example of a high-voltage power supply board 10, wherein FIG. 2A is a plan view showing the front surface of the board and FIG. 2B is a plan view showing the back surface of the board.

The high-voltage power supply board 10 has a rectangular outline. Herein, a description will be given of a high-voltage power supply board 10 having a square shape. First high-voltage generating circuits 11 and second high-voltage generating circuits 12 are mounted on the front surface (the same applies throughout this embodiment) of the high-voltage power supply board 10. In this embodiment, an example is shown in which four first high-voltage generating circuits 11 and four second high-voltage generating circuits 12 are mounted on the board.

The first high-voltage generating circuits 11 are circuits that use power supplies fed from the outside to generate high-voltage power to be output to the drum units. The first high-voltage generating circuits 11 are arranged side-by-side on a region of the high-voltage power supply board 10 located alongside of one lateral edge 101 of the board. For each first high-voltage generating circuit 11, a first output terminal 111 which is connected to the first high-voltage generating circuit 11 and from which high-voltage power generated by the first high-voltage generating circuit 11 is to be output to the outside is provided on the back surface of the board. The plurality of first output terminals 111 are arranged side-by-side on a region of the back surface of the high-voltage power supply board 10 located alongside of the one lateral edge 101 of the board. The first output terminals 111 are terminals from which high-voltage power is to be output to the drum units. Around each of the first output terminals 111 on the back surface of the board, wiring and soldering are provided which are necessary for mounting the associated first high-voltage generating circuit 11 on the board. The wiring and soldering associated with each of the first output terminals 111 are disposed at an insulating distance D1 from the wiring and soldering associated with each adjacent one of the other first output terminals 111.

The second high-voltage generating circuits 12 are circuits that use power supplies from the outside to generate high-voltage power to be output to the developing units. The second high-voltage generating circuits 12 are arranged side-by-side on a region of the high-voltage power supply board 10 located alongside of the other lateral edge 102 of the board opposite to the one lateral edge 101. For each second high-voltage generating circuit 12, a second output terminal 121 which is connected to the second high-voltage generating circuit 12 and from which high-voltage power generated by the second high-voltage generating circuit 12 is to be output to the outside is provided on the back surface of the board. The plurality of second output terminals 121 are arranged side-by-side on a region of the back surface of the high-voltage power supply board 10 located alongside of the lateral edge 102 of the board. The second output terminals 121 are terminals from which high-voltage power is to be output to the developing units. Around each of the second output terminals 121 on the back surface of the board, wiring and soldering are provided which are necessary for mounting the associated second high-voltage generating circuit 12 on the board. The wiring and soldering associated with each of the second output terminals 121 are disposed at an insulating distance D2 from the wiring and soldering associated with each adjacent one of the other second output terminals 121.

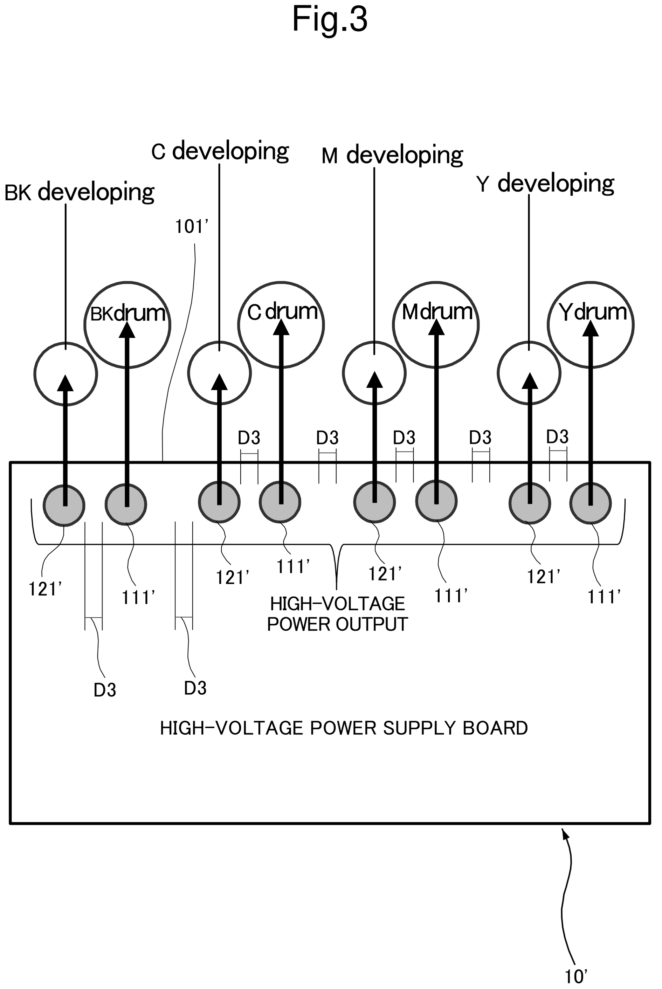

As just described, the wiring and soldering associated with each of the first output terminals 111 are disposed at an insulating distance D1 from the wiring and soldering associated with each adjacent one of the other first output terminals 111 on the region of the high-voltage power supply board 10 located alongside of the one lateral edge 101 thereof, while the wiring and soldering associated with each of the second output terminals 121 are disposed at an insulating distance D2 from the wiring and soldering associated with each adjacent one of the other second output terminals 121 on the region of the high-voltage power supply board 10 located alongside of the other lateral edge 102 thereof. Unlike this, if, as in a comparative example shown in FIG. 3, first output terminals 111' for drum units and second output terminals 121' for developing units are arranged side-by-side on a region of a high-voltage power supply board 10' located alongside of one lateral edge 101' of the board, an insulating distance D3 needs to be provided between each adjacent pair of first output terminal 111' for a drum unit and second output terminal 121' for a developing unit. As a result, the high-voltage power supply board 10' in the comparative example needs to have a larger dimension in a direction of extension of the one lateral edge 101' than the high-voltage power supply board 10 according to this embodiment in which either the first output terminals 111 or the second output terminals 121 are provided on one lateral edge of the board. Therefore, the high-voltage power supply board 10 according to this embodiment can be reduced in size as compared to the high-voltage power supply board 10' shown in the comparative example and, thus, the location constraint based on which the high-voltage power supply board 10 is to be disposed in the interior of the apparatus body 110 of the image forming apparatus 1 can be reduced.

Furthermore, the front surface of the board is provided with a connector 14 to which wiring for use in inputting control signals to be output to the first high-voltage generating circuits 11 and the second high-voltage generating circuits 12 is to be connected. The connector 14 is provided on a region of the high-voltage power supply board 10 located close to a lateral edge 103 of the high-voltage power supply board 10 orthogonal to the one lateral edge 101 and the other lateral edge 102 thereof and in the middle (inclusive of a predetermined nearby region around the middle) between the one lateral edge 101 and the other lateral edge 102.

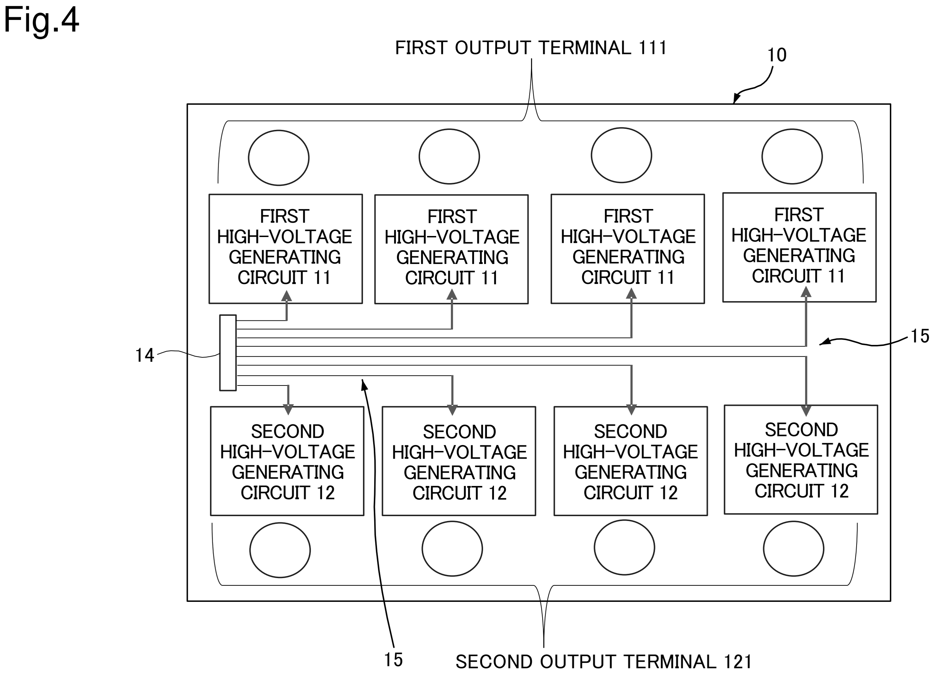

FIG. 4 is a picture illustrating an example of wiring patterns on the high-voltage power supply board 10 through which the connector 14 is connected to the first high-voltage generating circuit 11 and the second high-voltage generating circuits 12. In a space on the high-voltage power supply board 10 located between the connector 14 and each of the first high-voltage generating circuits 11 and the second high-voltage generating circuits 12, wiring patterns 15 are provided via which the above control signals are to be output to the first high-voltage generating circuits 11 and the second high-voltage generating circuits 12. In the example shown in this embodiment, the connector 14 includes a plurality of control signal output terminals and a wiring pattern 15 is provided for each of the plurality of control signal output terminals. Each of the wiring patterns 15 is connected to an associated one of the first high-voltage generating circuits 11 and the second high-voltage generating circuits 12.

When, as described so far, the first output terminals 111 are disposed on the region of the high-voltage power supply board 10 located alongside of the one lateral edge 101, the second output terminals 121 are disposed on the region of the board located alongside of the other lateral edge 102, and the connector 14 is disposed at the above-described location, the circuits leading from the connector 14 to the first output terminals 111 can be disposed separately from the circuits leading from the connector 14 to the second output terminals 121, in a manner that the former circuits for the drum units are located on the one lateral edge 101 side and the latter circuits for the developing units are located on the other lateral edge 102 side, which provides an effective use of the area on the board surface and facilitates the wiring pattern design and the parts layout.

Furthermore, since the connector 14 is disposed on the region of the high-voltage power supply board 10 in the middle between the one lateral edge 101 and the other lateral edge 102 as described above, the connector 14 is less likely to be affected by noises from the first output terminals 111 disposed on the one lateral edge 101 side and the second output terminals 121 disposed on the other lateral edge 102 side.

In addition, since the connector 14 is disposed at the above location, the board area for the first high-voltage generating circuits 11 and the board area for the second high-voltage generating circuits 12 can be evenly ensured. Therefore, the wiring patterns 15 extending from the connector 14 to the first high-voltage generating circuits 11 and second high-voltage generating circuits 12 can be designed to have the same configuration between the developing unit side and the drum unit side as shown in FIG. 4, which facilitates the design of the wiring patterns 15.

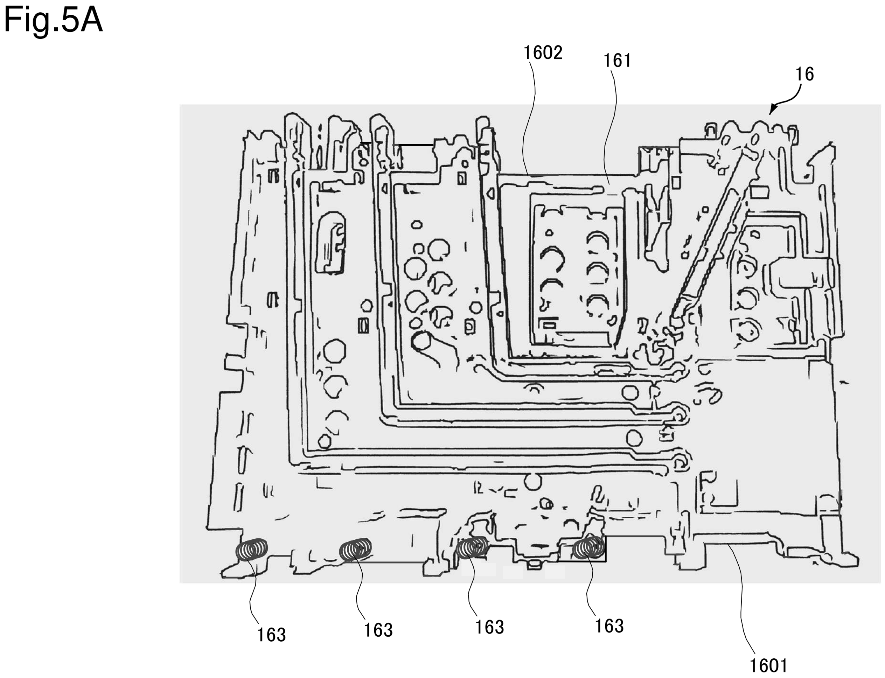

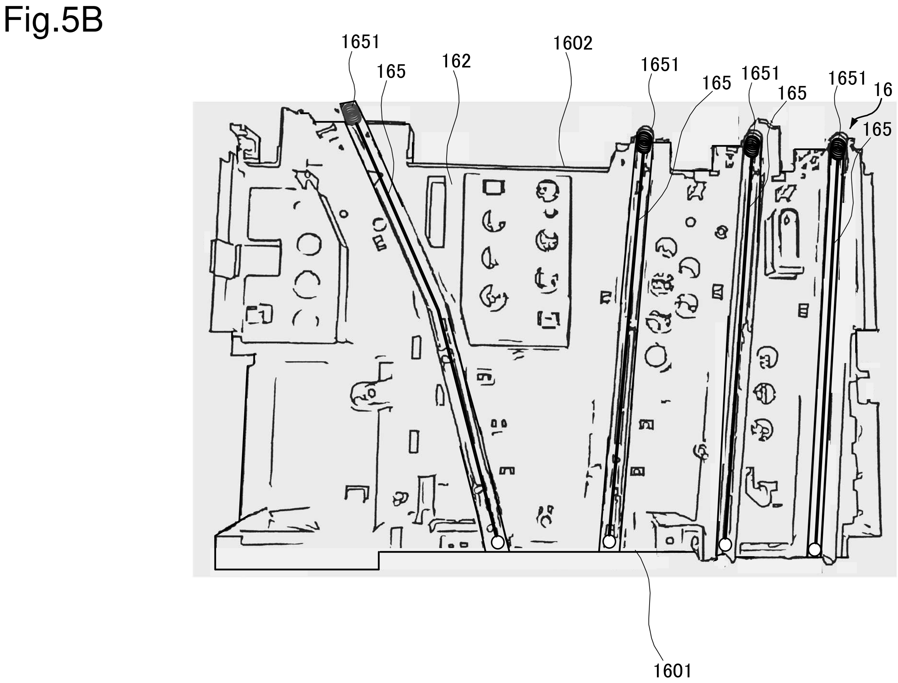

Next, a description will be given of a mount to which the high-voltage power supply board 10 is to be mounted in the interior of the apparatus body 110 of the image forming apparatus 1. FIG. 5A is a view showing an example of a mount 16 on which the high-voltage power supply board 10 is to be mounted, and a plan view showing one side of the mount 16. FIG. 5B is a view showing the example of the mount 16 on which the high-voltage power supply board 10 is to be mounted, and a plan view showing the other side of the mount 16.

The mount 16 on which the high-voltage power supply board 10 is to be mounted is provided, on one side 161 thereof, with side-by-side arranged contacts 163 to be connected with the respective second output terminals 121 of the high-voltage power supply board 10. When the high-voltage power supply board 10 is mounted on and fixed to the mount 16 by screw fastening or other means, the second output terminals 121 make contact and electrically connect with the respective contacts 163 located at their corresponding locations. Meanwhile, the contacts 163 are electrically connected to the respective high-voltage power output lines 165 provided on the other side 162 of the mount 16. The high-voltage power output lines 165 are provided for the individual contacts 163.

Each of the high-voltage power output lines 165 is run to extend on the other side 162 of the mount 16 from one lateral edge 1601 of the mount 16 where the contacts 163 are disposed to the other lateral edge 1602 of the mount 16 located opposite to the one lateral edge 1601. Since the high-voltage power supply board 10 is mounted on the one side 161 of the mount 16, the high-voltage power output lines 165 disposed on the other side 162 of the mount 16 have insulating distances sufficiently away from the circuits and soldering surfaces provided on the board surface of the high-voltage power supply board 10 mounted on the mount 16.

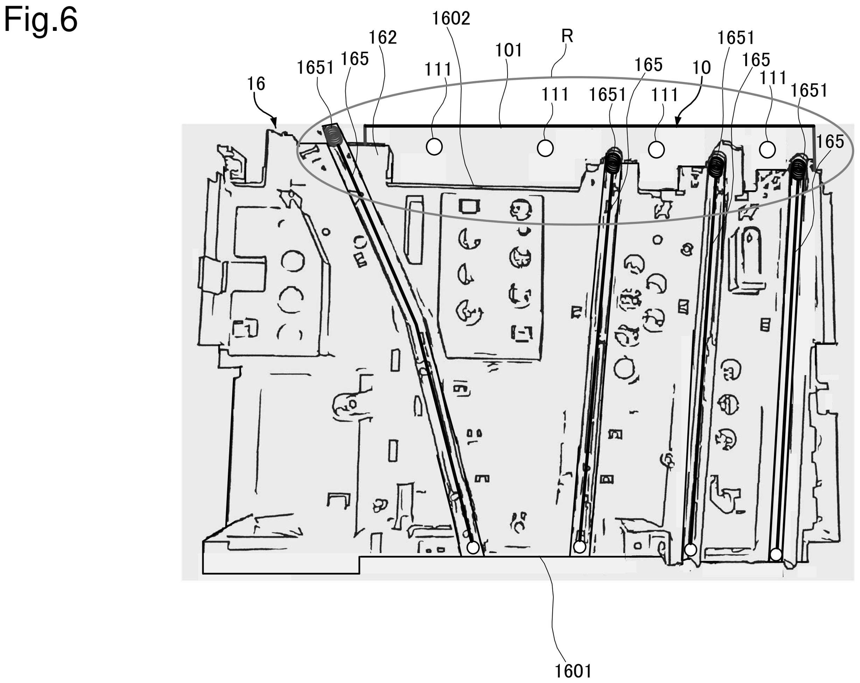

Furthermore, the high-voltage power supply board 10 is configured to have a size that, when mounted on the mount 16, allows the first output terminals 111 to be located alongside of the other lateral edge 1602 of the mount 16. Specifically, the high-voltage power supply board 10 is configured to have a size that, when mounted on the mount 16, allows the first output terminals 111 to be located laterally to the other lateral edge 1602 of the mount 16 and exposed beyond the mount 16 as shown in FIG. 6.

Each of the high-voltage power output lines 165 is provided, at an end thereof located on the other lateral edge 1602, with an output terminal 1651 from which high-voltage power is to be output to the associated operating unit disposed in the interior of the apparatus body 110 of the image forming apparatus 1. In this embodiment, the contacts for the developing units are connected to the output terminals 1651 and high-voltage power is supplied through the output terminals 1651 to the developing units. As shown in FIG. 6, the high-voltage power output lines 165 are disposed to extend to locations where, when the high-voltage power supply board 10 is mounted on the mount 16, the output terminals 1651 are disposed side-by-side with the first output terminals 111 exposed laterally to the other lateral edge 1602 of the mount 16. Thus, when the high-voltage power supply board 10 is mounted on the mount 16, both the work for connecting power supply to the drum units and the work for connecting power supply to the developing units can be done in a region R shown in FIG. 6, which improves the work efficiency.

Specifically, as to the high-voltage power supply board 10 according to this embodiment, after the high-voltage power supply board 10 is mounted on the mount 16 and when the high-voltage power supply board 10 is mounted in the interior of the apparatus body 110 of the image forming apparatus 1 by the same work as that with the use of the high-voltage power supply board 10' according to the comparative example shown in FIG. 3, both the work for connecting power supply to the drum units and the work for connecting power supply to the developing units can be done. Furthermore, as to the high-voltage power supply board 10 according to this embodiment, the board size in the direction of arrangement of the first output terminals 111 and the second output terminals 121 can be reduced as compared to the high-voltage power supply board 10' according to the comparative example.

Therefore, in the high-voltage power supply board 10 according to this embodiment, the size of the high-voltage power supply board 10 with terminals from which high-voltage power is supplied to the operating units can be reduced, and, thus, the location constraint based on which the board is to be disposed in the apparatus body can be reduced.

When, in the general image forming apparatus, terminals from which high-voltage power is to be supplied to both of two types of units are arranged in a line on a region of a board located alongside of one of two lateral edges of the board forming longer sides, not only a board space for parts and circuits to be disposed on the board surface but also insulating distances between adjacent terminals need to be ensured, which increases the board size in the direction of extension of the longer sides. In the case of a high-voltage power supply board, the above insulating distances need to be larger because the output power has a high voltage. As seen from the above, when the board size increases in the longitudinal direction, a location constraint for the board in the apparatus body becomes severer.

In contrast, in the above embodiment, the size of the high-voltage power supply board with terminals from which high-voltage power is supplied to the operating units can be reduced, and, thus, the location constraint based on which the board is to be disposed in the apparatus body can be reduced.

The present invention is not limited to the structure of the above embodiment and can be modified in various ways. For example, although the description in the above embodiment has been given of the image forming apparatus 1 as an example of the electronic device according to the present invention, the electronic device according to the present invention is not limited to such an image forming apparatus and encompasses a wide variety of electronic devices having a mechanism that supplies high-voltage power to operating units.

The structure, configuration, and processing of the above embodiment described with reference to FIGS. 1 to 6 are merely illustrative of the present invention and are not intended to limit the present invention to them.

## Claims

1. A high-voltage power supply board (10) having a rectangular outline, the high-voltage power supply board (10) comprising:
a plurality of first output terminals (111) that are provided on a region of the high-voltage power supply board (10) located alongside of one lateral edge (101) thereof and output high-voltage power to first operating units; and
a plurality of second output terminals (121) that are provided on a region of the high-voltage power supply board (10) located alongside of another lateral edge (102) of the high-voltage power supply board (10) opposite to the one lateral edge (101) thereof and output high-voltage power to second operating units different from the first operating units.

2. The high-voltage power supply board (10) according to claim 1, wherein
for each of the first output terminals (111), a first high-voltage generating circuit (11) that generates high-voltage power to be output from the first output terminal (111) is mounted close to the first output terminal (111),
for each of the second output terminals (121), a second high-voltage generating circuit (12) that generates high-voltage power to be output from the second output terminal (121) is mounted close to the second output terminal (121),
a connector (14) to which wiring for use in inputting control signals to be output to the first high-voltage generating circuits (11) and the second high-voltage generating circuits (12) are to be connected is mounted close to a lateral edge (103) of the high-voltage power supply board (10) orthogonal to the one lateral edge (101) and the other lateral edge (102) and in the middle between the one lateral edge (101) and the other lateral edge (102), and,
wiring patterns (15) via which the control signals are to be output are provided to connect between the connector (14) and each of the first high-voltage generating circuits (11) and the second high-voltage generating circuits (12).

3. An electronic device (1) comprising:
the high-voltage power supply board (10) according to claim 1 or 2; and
a mount (16) which is provided in an apparatus body and on which the high-voltage power supply board (10) is mounted,
wherein the mount (16) is provided with high-voltage output lines (165) each of which makes a connection with one of the first output terminal (111) and the second output terminal (121) and is wired from a location of the connection to a location close to the other of the first output terminal (111) and the second output terminal (121), while keeping an insulating distance from a soldering surface provided on the high-voltage power supply board (10).

4. The electronic device (1) according to claim 3, wherein the high-voltage power supply board (10) is mounted on the mount (16) with the first output terminals (111) exposed laterally to a lateral edge of the mount (16).

5. An image forming apparatus (1) comprising:
the high-voltage power supply board (10) according to claim 1 or 2;
an image forming device (120) comprising developing units as the first operating units and photosensitive drum units as the second operating units and capable of forming an image on a recording medium; and
a mount (16) which is provided in an apparatus body of the image forming apparatus (1) and on which the high-voltage power supply board (10) is mounted,
wherein the mount (16) is provided with high-voltage output lines (165) each of which makes a connection with one of the first output terminal (111) and the second output terminal (121) and is wired from a location of the connection to a location close to the other of the first output terminal (111) and the second output terminal (121), while keeping an insulating distance from a soldering surface provided on the high-voltage power supply board (10).
